# EUROPEAN PATENT APPLICATION

(11) **EP 4 589 382 A2**
(43) Date of publication of application: **23.07.2025**
(21) Application number: 25150430.4
(22) Date of filing: 07.01.2025
(51) Int. Cl.: G03F 7/00

(54) **IMPRINT METHOD, MOLD, IMPRINT APPARATUS AND ARTICLE MANUFACTURING METHOD**

(30) Priority: 18.01.2024 JP 2024006212
(71) Applicant: CANON KABUSHIKI KAISHA, Tokyo 146-8501 (JP)
(72) Inventor: ISHIDA, Masaki, Tokyo, 146-8501 (JP); YAMAMOTO, Kiyohito, Tokyo, 146-8501 (JP)
(74) Representative: TBK

(57) **Abstract**

An imprint method of forming a pattern in an imprint material arranged on each of a first region on a substrate and a second region including an overlap region overlapping an edge of the first region, including forming, in the imprint material on the first region, a first pattern including a main pattern and a first portion formed on an overlay pattern formed in the overlap region, and forming, in the imprint material on the second region, a second pattern including a main pattern and a second portion covering the first portion of the first pattern, wherein in the forming the second pattern, the second pattern is formed such that a film thickness of a pattern formed in the overlap region is greater than a film thickness of the main pattern of the second pattern.

## Description

### BACKGROUND OF THE INVENTION

### Field of the Invention

The present invention relates to an imprint method, a mold, an imprint apparatus and an article manufacturing method.

### Description of the Related Art

In a manufacturing step of a semiconductor element, a MEMS, or the like, an imprint apparatus is used that forms a predetermined pattern by arranging an imprint material (a liquid fluid including an uncured resin and the like) on a substrate and pressing (contacting) a mold having undergone unevenness processing against the imprint material. The imprint apparatus optically detects overlay patterns respectively provided on the mold and the substrate, thereby achieving highly precise overly between the mold and the substrate. Thus, the imprint apparatus can form, on the substrate, a pattern having a fine structure on the order of several nm.

Relating to the imprint apparatus, Japanese Patent Laid-Open No. 2014-175620 proposes a technique for preventing formation of a region without an imprint material, that is, formation of a gap between a plurality of imprint regions (shot regions) on a substrate on which an imprint process is executed. Japanese Patent Laid-Open No. 2014-175620 discloses a method in which the imprint process is executed on each imprint region so as to overlap the outer peripheral portion (edge) of the adjacent imprint region on the substrate.

On the other hand, when forming the circuit pattern of a semiconductor element, the overlay (alignment) accuracy between a pattern already formed on a substrate and a pattern to be formed is important. Therefore, as the overlay method for a substrate and a mold, the imprint apparatus generally employs a die-by-die method. The die-by-die method is a method of, for each imprint region on the substrate, detecting an overlay pattern provided on the substrate and an overlay pattern provided on the mold and correcting a shift in the positional relationship (relative position) between the substrate and the mold. Accordingly, it is necessary to form the overlay pattern in each of a plurality of imprint regions on the substrate, thereby forming a large number of overlay patterns on the substrate.

However, since the overlay pattern on the substrate used when executing the imprint process for the first layer is cut and deformed through an etching process, it cannot be used for the imprint process for the second and subsequent layers. Hence, in order to execute the imprint process for the second and subsequent layers, an overlay pattern usable for the second layer must be provided in a region different from the overlay pattern used for the first layer. This increases the region where overlay patterns are formed on the substrate.

### SUMMARY OF THE INVENTION

The present invention provides a technique advantageous in protecting an overlay pattern formed on a substrate, thereby reducing the region where overlay patterns are formed.

The present invention in its first aspect provides an imprint method as specified in claims 1 to 5.

The present invention in its second aspect provides a mold as specified in claims 6 to 12.

The present invention in its third aspect provides an imprint apparatus as specified in claim 13.

The present invention in its fourth aspect provides an article manufacturing method as specified in claim 14.

Further aspects of the present invention will become apparent from the following description of exemplary embodiments with reference to the attached drawings.

### BRIEF DESCRIPTION OF THE DRAWINGS

Fig. 1 is a schematic view illustrating basic configurations of an imprint apparatus according to an aspect of the present invention.
Fig. 2 is a view illustrating configurations of a mold in a conventional technique.
Figs. 3A and 3B are views for describing the conventional technique.
Figs. 4A to 4C are views for describing configurations of a mold and configurations of a substrate in the first embodiment.
Fig. 5 is a view illustrating the first pattern and the second pattern formed in the first imprint region and the second imprint region, respectively.
Fig. 6 is a view illustrating an example of the order of an imprint process for a plurality of imprint regions on the substrate.
Fig. 7 is a flowchart for describing the imprint process in the first embodiment.
Figs. 8A and 8B are views for describing configurations of a mold and configurations of a substrate in the second embodiment.
Fig. 9 is a view illustrating the first pattern and the second pattern formed in the first imprint region and the second imprint region, respectively.
Figs. 10A and 10B are views for describing configurations of a mold and configurations of a substrate in the third embodiment.
Fig. 11 is a view illustrating the first pattern and the second pattern formed in the first imprint region and the second imprint region, respectively.
Figs. 12A to 12F are views for describing an article manufacturing method.

### DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

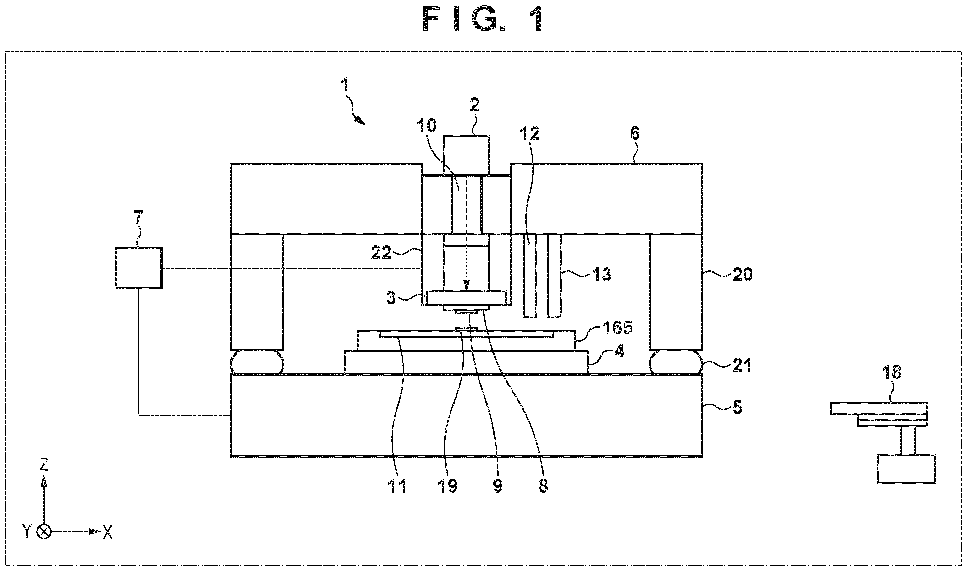

Fig. 1 is a schematic view illustrating basic configurations of an imprint apparatus 1 according to an aspect of the present invention. The imprint apparatus 1 is a lithography apparatus employed in a lithography step that is a manufacturing step for a device such as a semiconductor element, a liquid crystal display element, or a magnetic storage medium to form a pattern on a substrate. The imprint apparatus 1 forms a pattern of an imprint material on a substrate by molding the imprint material on the substrate using a mold. In this embodiment, the imprint apparatus 1 brings an imprint material arranged (supplied or applied) on a substrate into contact with a mold, and applies curing energy to the imprint material, thereby forming a pattern of a cured product to which the pattern of the mold is transferred.

As the imprint material, a material (curable composition) to be cured by receiving curing energy is used. An example of the curing energy that is used is electromagnetic waves, heat, or the like. As the electromagnetic waves, for example, infrared light, visible light, ultraviolet light, and the like selected from the wavelength range of 10 nm (inclusive) to 1 mm (inclusive) is used.

The curable composition is a composition cured by light irradiation or heating. The photo-curable composition cured by light irradiation contains at least a polymerizable compound and a photopolymerization initiator, and may contain a nonpolymerizable compound or a solvent, as needed. The nonpolymerizable compound is at least one type of material selected from a group comprising of a sensitizer, a hydrogen donor, an internal mold release agent, a surfactant, an antioxidant, a polymer component, and the like.

The imprint material may be applied in a film shape onto the substrate by a spin coater or a slit coater. The imprint material may be applied, onto the substrate, in a droplet shape or in an island or film shape formed by connecting a plurality of droplets using a liquid injection head. The viscosity (the viscosity at 25°C) of the imprint material is, for example, 1 mPa·s (inclusive) to 100 mPa·s (inclusive).

As the substrate, glass, ceramic, a metal, a semiconductor, a resin, or the like is used, and a member made of a material different from that of the substrate may be formed on the surface of the substrate, as needed. More specifically, examples of the substrate include a silicon wafer, a semiconductor compound wafer, silica glass, and the like.

In the specification and the accompanying drawings, directions will be indicated on an XYZ coordinate system in which directions parallel to a plane on which the substrate is placed are defined as the X-Y plane. Directions parallel to the X-axis, the Y-axis, and the Z-axis of the XYZ coordinate system are the X direction, the Y direction, and the Z direction, respectively. A rotation about the X-axis, a rotation about the Y-axis, and a rotation about the Z-axis are θX, θY, and θZ, respectively.

In this embodiment, as the curing method of an imprint material, the imprint apparatus 1 employs a photo-curing method of curing the imprint material by irradiation of light such as ultraviolet light. Accordingly, the imprint apparatus 1 performs an imprint process in which a pattern of an imprint material is formed on a substrate by irradiating the imprint material with light in a state in which a mold is in contact with the imprint material on the substrate. However, as the curing method of an imprint material, the imprint apparatus 1 may employ a heat-curing method of curing the imprint material by applying heat.

As illustrated in Fig. 1, the imprint apparatus 1 includes an irradiation unit 2, a mold holding unit 3, a mold driving mechanism 22, a substrate stage 4, a dispenser 12, a measurement unit 13, and a control unit 7. The imprint apparatus 1 includes a base plate 5 supporting the substrate stage 4, a bridge plate 6 supporting the mold holding unit 3, and support columns 20 extending from the base plate 5 and supporting the bridge plate 6 via vibration isolators 21 that reduce a vibration transmitted from the floor to the bridge plate 6. The imprint apparatus 1 includes a substrate conveyance mechanism 18 that conveys a substrate 11 between the substrate stage 4 and the outside of the imprint apparatus 1, and a mold conveyance mechanism (not illustrated) that conveys a mold 8 between the mold holding unit 3 and the outside of the imprint apparatus 1.

In an imprint process, the irradiation unit 2 irradiates an imprint material 19 on the substrate with light 10 for curing the imprint material 19 via the mold 8. The irradiation unit 2 includes, for example, a light source that emits the light 10, and an optical element that adjusts the light 10 from the light source to a state suitable for the imprint process.

The mold 8 has, for example, a rectangular outer peripheral shape. The surface of the mold 8 to face the substrate 11 includes a pattern region 9 where a pattern (circuit pattern or the like) to be formed on the substrate 11 is formed. The mold 8 is made of a material that can transmit the light 10, such as quartz.

The mold holding unit 3 is a head having a function of holding the mold 8. The mold holding unit 3 holds the mold 8 by attracting, by a vacuum suction force or an electrostatic force, the outer peripheral region other than the irradiation surface of the mold 8 which is irradiated with the light 10. For example, if the mold holding unit 3 holds the mold 8 by a vacuum suction force, the mold holding unit 3 is connected to a vacuum pump (not illustrated) installed outside, and switches holding/non-holding (attachment/detachment) of the mold 8 by ON/OFF of the vacuum pump.

The mold driving mechanism 22 is a mechanism that drives the mold holding unit 3 holding the mold 8 to perform an operation of bringing the mold 8 into contact with the imprint material 19 on the substrate and an operation of separating the mold 8 from the cured imprint material 19 on the substrate. The mold driving mechanism 22 includes, for example, an actuator such as a linear motor or an air cylinder to drive the mold holding unit 3 (mold 8). In order to cope with highly accurate positioning of the mold 8, the mold driving mechanism 22 may be formed from a plurality of driving systems including a coarse driving system, a fine driving system, and the like. The mold driving mechanism 22 may have a function of adjusting not only the Z-direction position of the mold 8 (the mold holding unit 3 holding the mold 8) but also the X-direction position, the Y-direction position, the rotation and tilt about the Z-axis, and the like. Note that the operation of bringing the mold 8 into contact with the imprint material 19 on the substrate and the operation of separating the mold 8 from the cured imprint material 19 on the substrate may be implemented by driving the substrate stage 4 (substrate 11) in the Z direction. Alternatively, the operation of bringing the mold 8 into contact with the imprint material 19 on the substrate and the operation of separating the mold 8 from the cured imprint material 19 on the substrate may be implemented by driving both the mold holding unit 3 (mold 8) and the substrate stage 4.

The substrate 11 is a substrate onto which the pattern of the mold 8 is transferred. The imprint material 19 to be cured by irradiation of the light 10 is arranged on the surface (surface to be processed) of the substrate 11. More specifically, the imprint material 19 is arranged in an imprint region to undergo an imprint process on the surface of the substrate 11.

The substrate stage 4 is a stage that holds the substrate 11. The substrate stage 4 is used to execute alignment between the substrate 11 and the mold 8 when bringing the mold 8 into contact with the imprint material 19 on the substrate. The substrate stage 4 includes a substrate holding unit 165 that attracts and holds the substrate 11 by a suction force, and an actuator (not illustrated) that drives the substrate holding unit 165 (substrate 11 held thereby) in each axis direction. For example, a linear motor, a planar motor, or the like is applied to the actuator. The substrate stage 4 may be formed from a plurality of driving systems including a coarse driving system, a fine driving system, and the like for each of the X-axis direction and the Y-axis direction. The substrate stage 4 may have a function of adjusting not only the X- and Y-direction positions of the substrate 11 but also the Z-direction position, the rotation about the Z-axis, the rotations and tilts about the X- and Y-axes, and the like.

In this embodiment, the dispenser 12 is provided near the mold holding unit 3, and has a function of discharging and arranging the uncured imprint material 19 on the substrate 11 held by the substrate stage 4. The amount of the imprint material 19 supplied from the dispenser 12 onto the substrate 11 is decided based on the target film thickness of the imprint material 19 to be arranged on the substrate, the density of the pattern of the imprint material 19 to be formed on the substrate, and the like.

The measurement unit 13 is used to execute alignment between the substrate 11 and the mold 8. More specifically, the measurement unit 13 is used to adjust the positional relationship (relative position) between the substrate 11 and the mold 8 to overlay the pattern already formed on the substrate and the pattern of the mold 8 (the pattern to be formed). In this embodiment, the measurement unit 13 optically detects the overlay pattern already formed on the substrate and the overlay pattern provided on the mold 8, and measures the positional shift and shape shift between these overlay patterns.

The control unit 7 is formed from an information processing apparatus (computer) including a CPU, a memory, and the like. The control unit 7 operates the imprint apparatus 1 by comprehensively controlling the respective units of the imprint apparatus 1 in accordance with a program stored in the storage unit. The control unit 7 may be formed integrally with the imprint apparatus 1 (in a common housing), or may be formed separated from the imprint apparatus 1 (in another housing).

An imprint process performed by the imprint apparatus 1 will be described here. The imprint process is performed on each of a plurality of imprint regions on a substrate by the control unit 7 comprehensively controlling the respective units of the imprint apparatus 1.

First, the control unit 7 controls the substrate conveyance mechanism 18 to convey the substrate 11 to the substrate stage 4 (substrate holding unit 165), and causes the substrate stage 4 to hold the substrate 11. Then, to arrange the imprint material 19 on the target imprint region of the plurality of imprint regions on the substrate, the control unit 7 drives the substrate stage 4 to locate the target imprint region below the dispenser 12. Then, the control unit 7 controls the dispenser 12 to arrange the imprint material 19 on the target imprint region on the substrate.

Then, the control unit 7 drives the substrate stage 4 to locate, below the mold 8 (pattern region 9 thereof), the target imprint region on the substrate where the imprint material 19 is arranged. Then, the control unit 7 drives the mold holding unit 3 via the mold driving mechanism 22 to bring the mold 8 into contact with the imprint material 19 on the substrate (on the target imprint region). Thus, the imprint material 19 is filled in the pattern formed in the pattern region 9 of the mold 8.

Then, the control unit 7 controls the irradiation unit 2 to irradiate the imprint material 19 with the light 10 via the mold 8 in a state in which the mold 8 is in contact with the imprint material 19 on the substrate. With this, the imprint material 19 on the substrate is cured while being in contact with the mold 8.

Then, the control unit 7 drives the mold holding unit 3 via the mold driving mechanism 22 to separate the mold 8 from the cured imprint material 19 on the substrate. Thus, the pattern of the mold 8 is transferred to the imprint material 19 on the substrate (on the target imprint region).

By performing the imprint process including a series of processes described above on each of the plurality of imprint regions on the substrate, the pattern of the imprint material 19 (the pattern of a cured product with the pattern of the mold 8 transferred thereto) is formed on each imprint region.

A technique for overlaying the pattern already formed on the substrate and the pattern of the mold 8 (the pattern to be formed) will be described below.

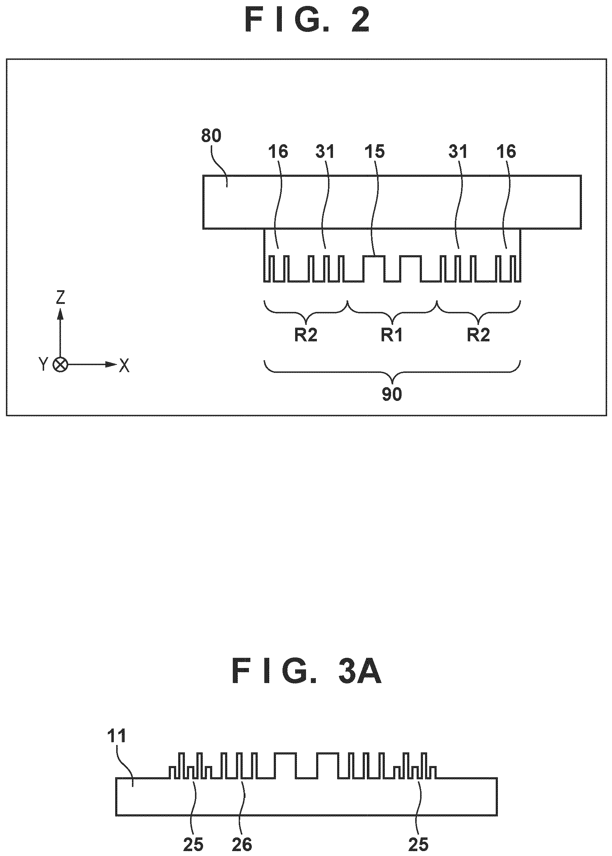

First, as the mold 8 applied to the imprint apparatus 1, configurations of a mold 80 in a conventional technique will be described with reference to Fig. 2. As illustrated in Fig. 2, a pattern region 90 of the pattern surface, which is the surface of the mold 80 to face the substrate 11, includes a main pattern region R1 and an overlay pattern region R2. In the main pattern region R1, for example, a main pattern 15 such as a circuit pattern to be transferred onto the substrate 11 is formed. In the overlay pattern region R2, an overlay pattern 16 corresponding to the overlay pattern formed on the substrate 11, and an overlay pattern 31 different from the overlay pattern 16 are formed. The overlay pattern 16 is a pattern used for alignment with the overlay pattern formed on the substrate 11. The overlay pattern 31 is a pattern used for alignment with the substrate 11 upon performing an imprint process for forming the second layer.

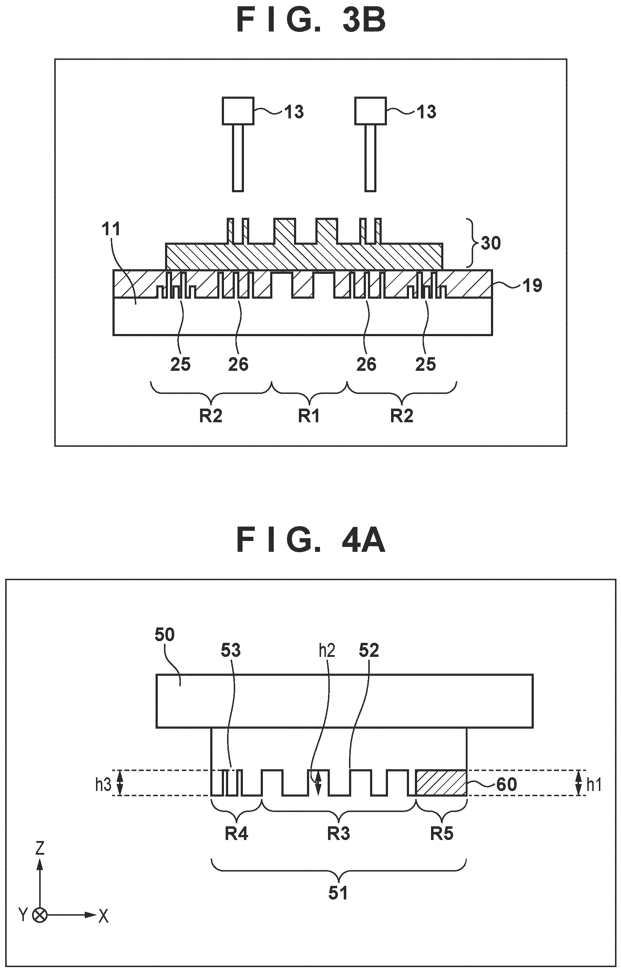

In a case of the mold 80 in the conventional technique (Fig. 2), the overlay pattern on the substrate used when performing the imprint process for forming the first layer (used with respect to the overlay pattern 16) becomes a pattern 25 cut and deformed through the etching process as illustrated in Fig. 3A. The pattern 25 is deformed from the original shape of the overlay pattern so the pattern 25 cannot be used for alignment between the mold 80 and the substrate 11. Hence, in a case of performing the imprint process for forming an upper layer 30 as the second layer, an overlay pattern 26 that corresponds to the overlay pattern 31 of the mold 80 needs to be formed on the substrate 11 in place of the pattern 25 as illustrated in Fig. 3B. Therefore, the overlay pattern region R2 of the pattern region 90 of the mold 80 (the region corresponding thereto where the overlay pattern on the substrate is formed) increases, and the main pattern region R1 (the region corresponding thereto where the main pattern on the substrate is formed) decreases.

Hence, the embodiment provides a technique for protecting, in the etching process, the overlay pattern formed on the substrate to eliminate the need to form the overlay pattern 26 on the substrate. More specifically, on the overlay pattern formed on the substrate, a pattern of the imprint material 19 that protects (covers) the overlay pattern is formed. Accordingly, in the embodiment, when forming the pattern of the imprint material 19 on each of the plurality of imprint regions on the substrate, the imprint process is performed such that the edges of the patterns of the imprint material 19 formed on adjacent imprint regions slightly overlap each other. In other words, the pattern of the imprint material 19 is formed on each of the first imprint region (first region) on the substrate and the second imprint region (second region) including the overlap region that overlaps the edge of the first imprint region.

### <First Embodiment>

With reference to Figs. 4A to 4C, configurations of a mold 50 in the first embodiment as a mold 8 applied to an imprint apparatus 1, and configurations of a substrate 70 in the first embodiment applied as a substrate 11 will be described.

As illustrated in Fig. 4A, a pattern region 51 to be brought into contact with an imprint material 19 on a substrate is provided on the surface of the mold 50 to face the substrate 70. In this embodiment, the pattern region 51 includes a main pattern region R3, an overlay pattern region R4, and a protection pattern region R5. In the main pattern region R1, for example, a main pattern 52 such as a circuit pattern to be transferred onto the substrate 70 (the imprint material 19 on the substrate) is formed. In the overlay pattern region R4, an overlay pattern 53 used for alignment with an overlay pattern 24 formed on the substrate is formed. In the protection pattern region R5, a protection pattern 60 for forming a pattern of the imprint material 19 on the overlay pattern 24 formed on the substrate is formed.

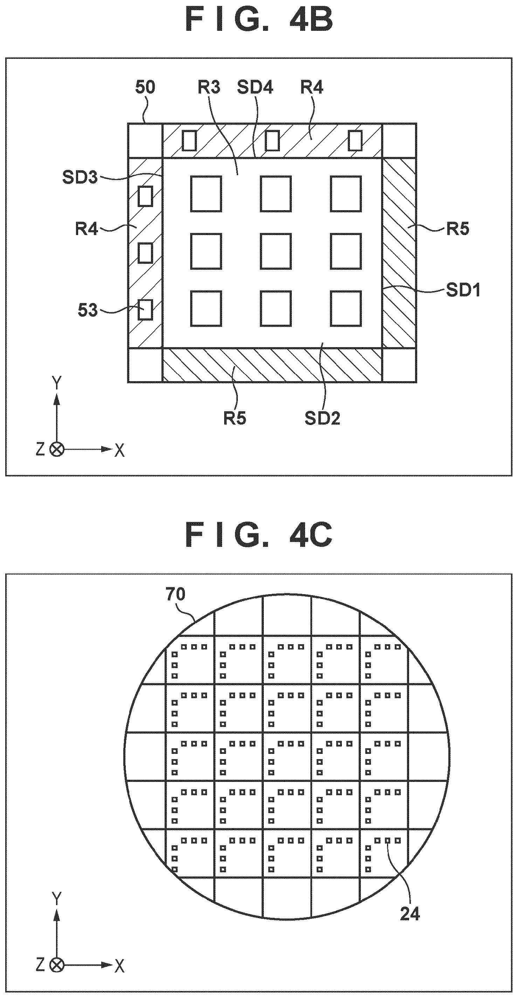

As illustrated in Fig. 4B, the main pattern region R3 has a rectangular outer peripheral shape defined by four sides of a first side SD1, a second side SD2, a third side SD3, and a fourth side SD4. The overlay pattern region R4 and the protection pattern region R5 are provided in the region (peripheral region) around the main pattern region R3. More specifically, the protection pattern region R5 is provided in the peripheral region of the main pattern region R3 along the first side SD 1 and the second side SD2 in contact with each other of four sides defining the outer peripheral shape (rectangular shape) of the main pattern region R3. The overlay pattern region R4 is provided in the peripheral region of the main pattern region R3 along the third side SD3 and the fourth side SD4 facing the first side SD 1 and the second side SD2, respectively, of four sides defining the outer peripheral shape (rectangular shape) of the main pattern region R3. In this manner, the protection pattern region R5 is provided to face the overlay pattern region R4 across the main pattern region R3.

The overlay pattern region R4 and the protection pattern region R5 have different structures. This is to ensure the overlap of the first pattern (edge thereof) and the second pattern (edge thereof) of the imprint material 19, which are formed by the imprint process on adjacent two imprint regions (the first region and the second region) on the substrate. For example, in the first pattern of the imprint material 19 formed in the imprint process on the first imprint region on the substrate, the pattern (first portion) in the region corresponding to the overlay pattern region R4 is a pattern R4'. In the second pattern of the imprint material 19 formed in the imprint process on the second imprint region adjacent to the first imprint region, the pattern (second pattern) in the region corresponding to the protection pattern region R5 is a pattern R5'. In this embodiment, the overlay pattern region R4 and the protection pattern region R5 have different structures to ensure that the pattern R5' corresponding to the protection pattern region R5 overlaps the pattern R4' corresponding to the overlay pattern region R4.

In the protection pattern region R5, as indicated by diagonal lines in Fig. 4A, the protection pattern 60 is formed as a recess formed by digging the surface to face the substrate 70 from the main pattern region R3, that is, a recess depressed from the main pattern region R3. In this embodiment, letting h1 be the depth of the protection pattern 60 (recess), h2 be the depth of the recess portion forming the main pattern 52, and h3 be the depth of the recess portion forming the overlay pattern 53, the respective patterns are formed to satisfy h1 ≥ h2 and h1 > h3. In other words, the depth of the protection pattern 60 (recess) is equal to or greater than the depth of the recess portion forming the main pattern 52, and is greater than the depth of the recess portion forming the overlay pattern 53.

Fig. 4C illustrates configurations of the substrate 70 used for the mold 50. As illustrated in Fig. 4C, in each of the plurality of imprint regions on the substrate 70, the overlay pattern 24 is formed at a position that faces the overlay pattern 53 of the mold 50 in the imprint process on each imprint region.

The first pattern and the second pattern of the imprint material 19 that are formed, by using the mold 50, in the first imprint region and the second imprint region, respectively, adjacent to each other on the substrate will be described. Here, in particular, the description will be given focusing on the pattern of the imprint material 19 in the overlap region of the edge of the first imprint region and the edge of the second imprint region.

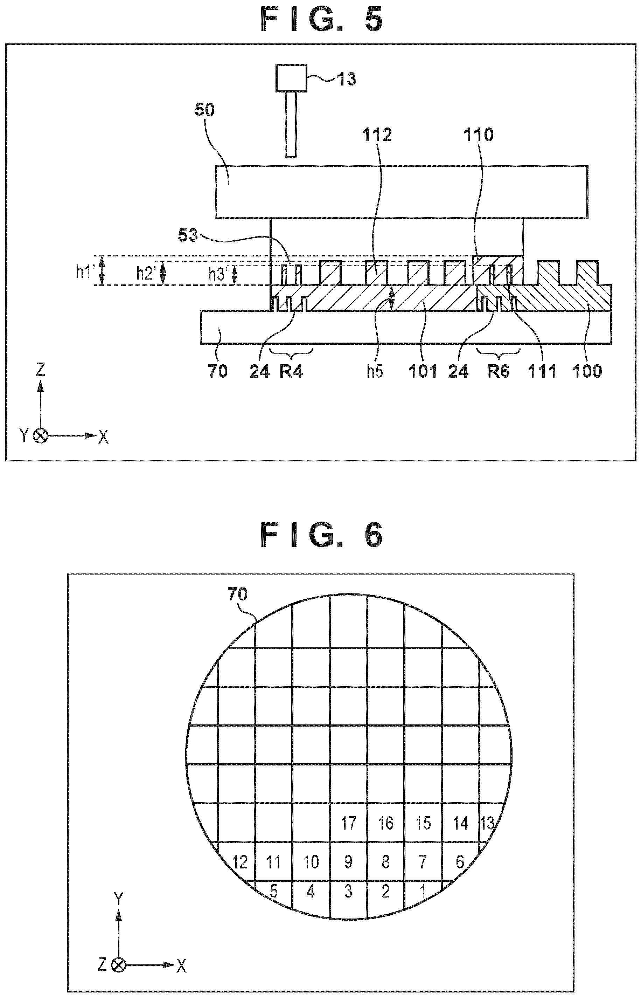

Fig. 5 is a view illustrating a first pattern 100 of the imprint material 19 formed on the first imprint region on the substrate, and a second pattern 101 of the imprint material 19 formed on the second imprint region adjacent to the first imprint region. The first pattern 100 and the second pattern 101 are formed on the respective imprint regions on the substrate by the imprint process using the mold 50. Fig. 5 illustrates an overlap region R6 as the region where the edge of the first imprint region and the edge of the second imprint region overlap. The overlay pattern 24 is formed in the overlap region R6.

Referring to Fig. 5, a first portion 111 of the first pattern 100 and a second portion 110 of the second pattern 101 overlap in the overlap region R6. Note that the first portion 111 corresponds to the pattern R4' in the region of the first pattern 100 corresponding to the overlay pattern region R4. The second portion 110 corresponds to the pattern R5' in the region of the second pattern 101 corresponding to the protection pattern region R5. In this manner, in the imprint process on the second imprint region, the protection pattern 60 of the mold 50 forms, on the overlay pattern 24 formed in the overlap region R6, the second portion 110 of the second pattern 101 that covers the first portion 111 of the first pattern 100. In other words, the main pattern of the first pattern 100 is formed in the central region of the first imprint region, and the second portion 110 of the second pattern 101 is formed in the peripheral region (overlap region R6) around the central region of the first imprint region.

The main pattern of the first pattern 101 corresponding to the main pattern 52 of the mold 50 is formed in the central region of the first imprint region. In this case, it can also be said that the second portion 110 of the second pattern 101 is formed in the peripheral region around the central region of the first imprint region (the overlap region R6 as the edges of the first imprint region and the second imprint region).

Here, let h5 be the residual film thickness of the first pattern 100 and the second pattern 101 formed by the imprint process. Further, let h1' be the height of the second portion 110 (pattern R5') of the second pattern 101, and h2' be the height of the main pattern 112 of the second pattern 101 corresponding to the main pattern 52 of the mold 50. Furthermore, let h3' be the height of the first portion 111 (pattern R4') of the first pattern 100, more specifically, the height of the pattern of the first pattern 100 corresponding to the overlay pattern 53 of the mold 50.

In this embodiment, the total value of the height h1' of the second portion 110 and the residual film thickness h5 is set greater than the total value of the height h3' of the first portion 111 and the residual film thickness h5. In other words, the height h1' of the second portion 110 is greater than the height h3' of the first portion 111. This can suppress that, in the imprint process on the second imprint region adjacent to the first imprint region, the mold 50 contacts and damages the first portion 111 of the first pattern 100 formed on the first imprint region.

In addition, in this embodiment, the total value of the height h1' of the second portion 110 and the residual film thickness h5 is set equal to or greater than the total value of the height h2' of the main pattern 112 of the second pattern 101 and the residual film thickness h5. In other words, in the second pattern 101, the height of the second portion 110 is equal to or greater than the height of the main pattern 112. In this manner, in this embodiment, the second pattern 101 is formed such that the total film thickness of the pattern (the first portion 111 and the second portion 110) of the imprint material 19 formed in the overlap region R6 becomes greater than the total film thickness of the main pattern 112 of the second pattern 101. This can suppress that, when transferring the main pattern 112 of the second pattern 101 onto the substrate 70, the overlay pattern 24 formed on the substrate 70 is cut and deformed through the etching process.

As has been described above, in this embodiment, it is possible to protect the overlay pattern 24 formed on the substrate, and the overlay pattern 24 can be reused when performing the imprint process for forming the upper layer on the first pattern 100 and the second pattern 101. Accordingly, it is unnecessary to form the overlay pattern 26 different from the overlay pattern 24 on the substrate and form the overlay pattern 31 corresponding to the overlay pattern 26 on the mold 80. Therefore, the main pattern region R3 of the mold 80 can be increased.

In this embodiment, it has been described that the total value of the height h1' of the second portion 110 of the second pattern 101 and the residual film thickness h5 is set equal to or greater than the total value of the height h2' of the main pattern 112 of the second pattern 101 and the residual film thickness h5. However, in practice, the height h1' of the second portion 110 of the second pattern 101 only needs to have a height that does not deform the overlay pattern 24 formed on the substrate.

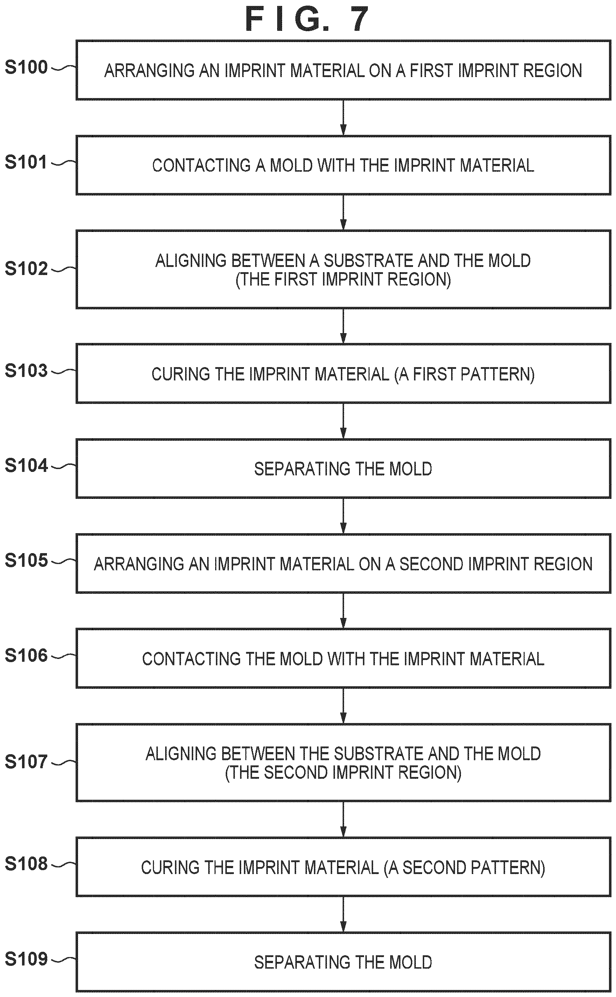

With reference to Figs. 6 and 7, the sequence of the imprint process in the first embodiment will be described below. In this embodiment, when forming the pattern of the imprint material 19 on each of the plurality of imprint regions on the substrate, the imprint process is performed such that the edges of the patterns of the imprint material 19 formed on adjacent imprint regions slightly overlap each other. More specifically, as described above, by using the imprint apparatus 1 to which the mold 50 is applied, the imprint process is performed on all the imprint regions on the substrate such that the second portion 110 of the second pattern 101 is formed on the first portion 111 of the first pattern 100. In this embodiment, the imprint process is performed on the plurality of imprint regions on the substrate, for example, in the order as illustrated in Fig. 6.

Fig. 7 is a flowchart for describing the imprint process in the first embodiment. As described above, the imprint process is performed by the control unit 7 comprehensively controlling the respective units of the imprint apparatus 1.

In step S100, the dispenser 12 arranges the imprint material 19 on the first imprint region as the imprint process target of the plurality of imprint regions on the substrate 70.

In step S101, the mold 50 (pattern region 51 thereof) is brought into contact with the imprint material 19 arranged on the first imprint region. More specifically, the substrate stage 4 is driven to locate the first imprint region with the imprint material 19 arranged thereon below the mold 50, and the mold driving mechanism 22 brings the mold 50 into contact with the imprint material 19 on the first imprint region. Thus, the imprint material 19 is filled in the pattern formed in the pattern region 51 of the mold 50.

In step S102, alignment between the substrate 70 and the mold 50 is performed. More specifically, the measurement unit 13 measures the relative position between the overlay pattern 24 formed on the substrate 70 (the overlap region R6 between the first shot region and the second shot region) and the overlay pattern 53 provided on the mold 50. Based on the relative position measured by the measurement unit 13, the substrate stage 4 is driven to align the first imprint region of the substrate 70 and the pattern region 51 of the mold 50. Accordingly, step S102 is also a step of aligning the substrate 70 to adjust the position where the first pattern 100 is formed in the first imprint region (first alignment step).

In step S103, in a state in which the mold 50 is in contact with the imprint material 19 arranged on the first imprint region, the imprint material 19 is cured. More specifically, the irradiation unit 2 irradiates the imprint material 19 with light via the mold 50, thereby curing the imprint material 19 arranged on the first imprint region.

In step S104, mold separation is performed. More specifically, the mold driving mechanism 22 separates the mold 50 from the cured imprint material 19 on the first imprint region.

In step S105, the dispenser 12 arranges the imprint material 19 on, of the plurality of imprint regions on the substrate 70, the second imprint region as the imprint process target adjacent to the first imprint region.

In step S106, the mold 50 (pattern region 51 thereof) is brought into contact with the imprint material 19 arranged on the second imprint region. More specifically, the substrate stage 4 is driven to locate the second imprint region with the imprint material 19 arranged thereon below the mold 50, and the mold driving mechanism 22 brings the mold 50 into contact with the imprint material 19 on the second imprint region. Thus, the imprint material 19 is filled in the pattern formed in the pattern region 51 of the mold 50.

In step S107, alignment between the substrate 70 and the mold 50 is performed. More specifically, the measurement unit 13 measures the relative position between the overlay pattern 24 formed on the substrate 70 (the overlap region between the second shot region and the third shot region adjacent to the second shot region) and the overlay pattern 53 provided on the mold 50. Based on the relative position measured by the measurement unit 13, the substrate stage 4 is driven to align the second imprint region of the substrate 70 and the pattern region 51 of the mold 50. With this, the overlay pattern 24 formed in the overlap region R6 overlaps the protection pattern 60 of the mold 50. Accordingly, step S107 is also a step of aligning the substrate 70 to adjust the position where the second pattern 101 is formed in the second imprint region (second alignment step).

In step S108, in a state in which the mold 50 is in contact with the imprint material 19 arranged on the second imprint region, the imprint material 19 is cured. More specifically, the irradiation unit 2 irradiates the imprint material 19 with light via the mold 50, thereby curing the imprint material 19 arranged on the second imprint region.

In step S109, mold separation is performed. More specifically, the mold driving mechanism 22 separates the mold 50 from the cured imprint material 19 on the second imprint region.

In this manner, the first pattern 100 and the second pattern 101 of the imprint material 19 are formed in the first imprint region and the second imprint region of the substrate 70, respectively. By repeating steps S105 to S109, the imprint process is performed on all the imprint regions of the substrate 70. With this, the pattern (the second portion 110 of the second pattern 101) of the imprint material 19 for protecting the overlay pattern 24 can be formed on the overlay pattern 24 formed in each imprint region of the substrate 70. Accordingly, it is possible to suppress that the overlay pattern 24 formed on the substrate 70 is cut and deformed through the etching process, so that the overlay pattern 24 can be reused when forming an upper layer. This contributes to reduction of the region for the overlay pattern 24 formed on the substrate 70.

### <Second Embodiment>

In the first embodiment, the overlay pattern 53 is provided in the peripheral region along two sides in contact with each other of four sides defining the rectangular outer peripheral shape of the main pattern region R3 of the mold 80 to perform alignment with the substrate 70. However, if the overlay pattern 53 is provided in the peripheral region all around the main pattern region R3 of the mold 50, the overlay accuracy can be improved and alignment can be performed even if the imprint region is narrow in the outer periphery of the substrate 70. Therefore, the second embodiment provides a technique that can protect the overlay pattern on a substrate and provide the overlay pattern all around the imprint region.

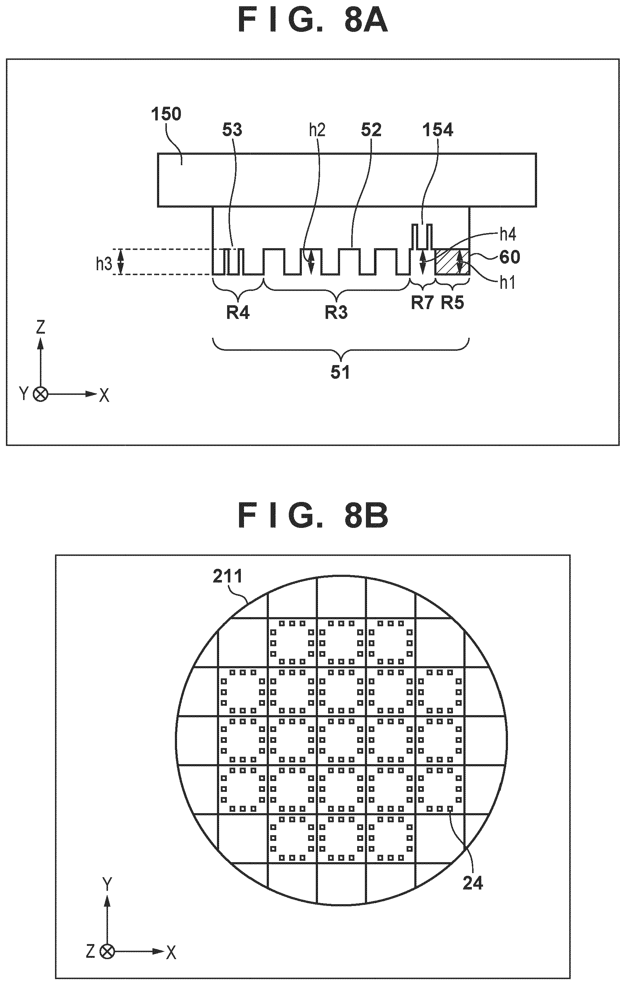

With reference to Figs. 8A and 8B, configurations of a mold 150 in the second embodiment as a mold 8 applied to an imprint apparatus 1, and configurations of a substrate 211 in the second embodiment applied as a substrate 11 will be described. Note that configurations of the mold 150 not described in this embodiment are similar to those of the mold 50.

As illustrated in Fig. 8A, in this embodiment, a pattern region 51 provided on the surface of the mold 150 to face the substrate 211 includes a main pattern region R3, an overlay pattern region R4, a protection pattern region R5, and an overlay pattern region R7. In the overlay pattern region R7, an overlay pattern 154 used for alignment with an overlay pattern 24 formed on a substrate is formed. The overlay pattern region R7 is provided in the peripheral region between the main pattern region R3 and the protection pattern region R5 along a first side SD 1 and a second side SD2 of four sides defining the rectangular outer peripheral shape of the main pattern region R3. Accordingly, an overlay pattern 53 and the overlay pattern 154 are formed in the peripheral region all around the main pattern region R3 of the mold 150.

In this embodiment, the recess forming a protection pattern 60 extends to the overlay pattern region R7 as illustrated in Fig. 8A. In other words, the overlay pattern region R7 is formed by a recess formed by digging the surface to face the substrate 211 from the main pattern region R3, and the overlay pattern 154 is formed by a recess portion formed in the recess. Hence, a depth h4 of the overlay pattern region R7 (recess) is greater than a depth h2 of the recess portion forming the main pattern 52.

In this manner, in this embodiment, the mold 150 has a structure in which the overlay pattern region R7 is provided outside the main pattern region R3, and the protection pattern region R5 (protection pattern 60) is provided further outside. With this, as illustrated in Fig. 8B, it is possible to perform alignment all around the imprint region by using the substrate 211 in which the overlay pattern 24 is provided all around each imprint region.

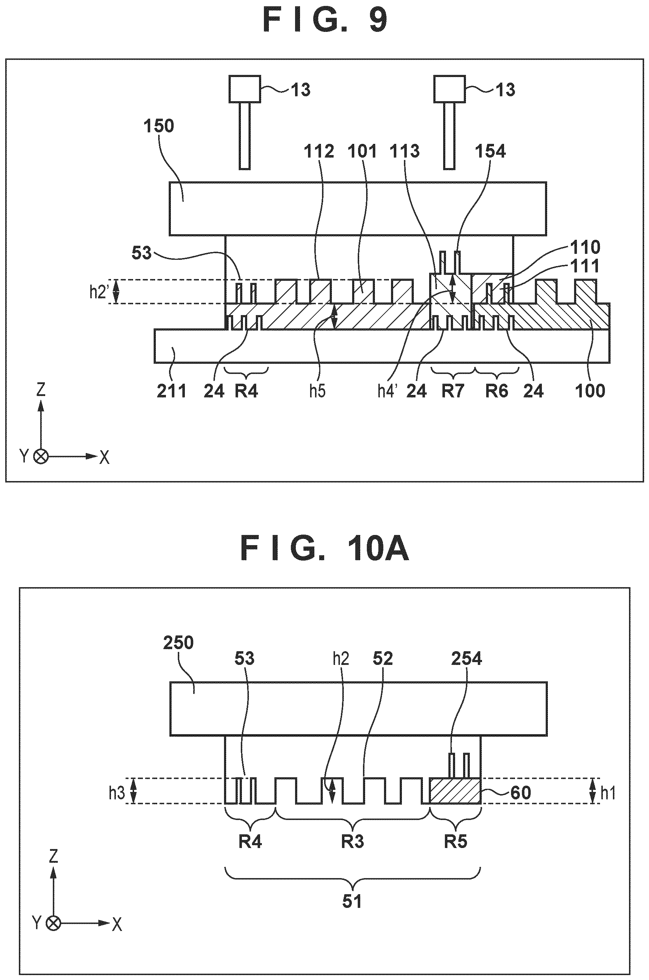

Fig. 9 is a view illustrating a first pattern 100 of an imprint material 19 formed on the first imprint region on the substrate, and a second pattern 101 of the imprint material 19 formed on the second imprint region adjacent to the first imprint region. The first pattern 100 and the second pattern 101 are formed in the respective imprint regions on the substrate by the imprint process using the mold 150. As in the first embodiment, the overlay pattern 24 formed in an overlap region R6 between the first imprint region and the second imprint region is protected by a first portion 111 of the first pattern 100 and a second portion 110 of the second pattern 101.

In this embodiment, in the second pattern 101 of the imprint material 19 formed by the imprint process on the second imprint region on the substrate, a pattern in the region corresponding to the overlay pattern region R7 is a third portion 113. In the overlay pattern region R7, the total value of a height h4' of the third portion 113 of the second pattern 101 and a residual film thickness h5 is set equal to or greater than the total value of a height h2' of a main pattern 112 of the second pattern 101 and the residual film thickness h5. In other words, in the second pattern 101, the height of the third portion 113 is equal to or greater than the height of the main pattern 112. In this manner, in this embodiment, the second pattern 101 is formed such that the total film thickness of the pattern (third portion 113) of the imprint material 19 formed on the overlay pattern region R7 is greater than the total film thickness of the main pattern 112 of the second pattern 101. This can suppress that, when transferring the main pattern 112 of the second pattern 101 onto the substrate 211, the overlay pattern 24 formed on the substrate 211 is cut and deformed through the etching process.

The sequence of the imprint process in the second embodiment is basically similar to that in the first embodiment, but alignment between the substrate 211 and the mold 150 in step S107 is different. In this embodiment, in step S107, alignment between the substrate 211 and the mold 150 is performed using not only the overlay pattern 24 formed in the overlay pattern region R4 but also the overlay pattern 24 formed in the overlay pattern region R7. Hence, in this embodiment, as compared to the first embodiment, the alignment accuracy between the substrate 211 and the mold 150, that is, the overlay accuracy between the pattern already formed on the substrate and the pattern to be formed can be improved.

### <Third Embodiment>

In the second embodiment, to implement the die-by-die method, the overlay pattern 24 needs to be formed for each imprint region on a substrate. In the third embodiment, the region (total area) for an overlay pattern 24 formed on a substrate is reduced by adjacent imprint regions on a substrate sharing the overlay pattern 24.

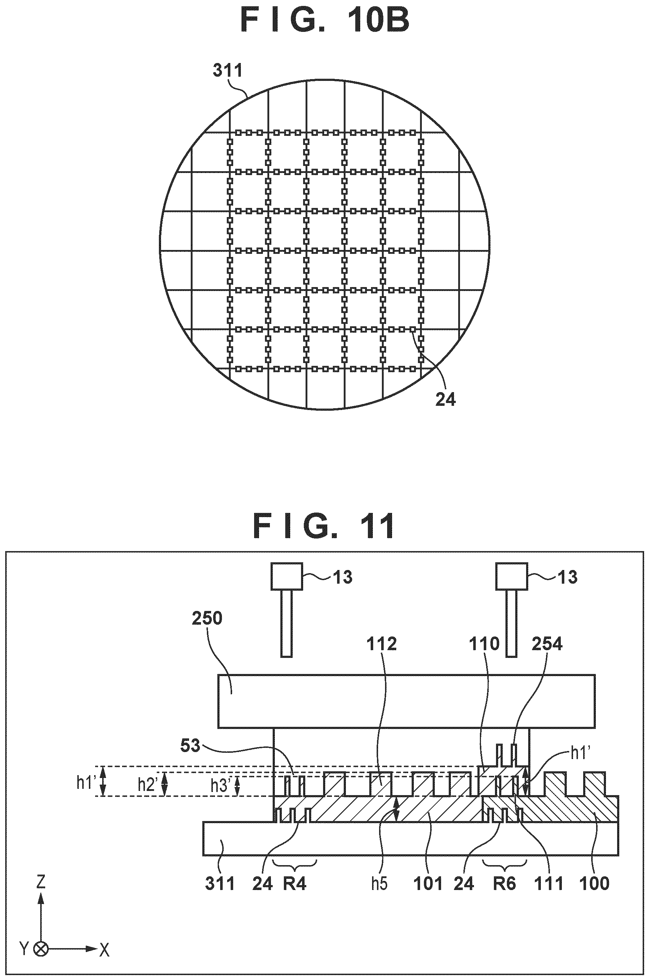

With reference to Figs. 10A and 10B, configurations of a mold 250 in the third embodiment as a mold 8 applied to an imprint apparatus 1, and configurations of a substrate 311 in the third embodiment applied as a substrate 11 will be described. Note that configurations of the mold 250 not described in this embodiment are similar to those of the mold 50.

As illustrated in Fig. 10A, in this embodiment, a pattern region 51 provided on the surface of the mold 250 to face the substrate 311 includes a main pattern region R3, an overlay pattern region R4, and a protection pattern region R5. In this embodiment, in the protection pattern region R5, in addition to a protection pattern 60, an overlay pattern 254 used for alignment with the overlay pattern 24 formed on the substrate is formed. The overlay pattern 254 is formed by a recess portion formed in a recess forming the protection pattern 60 immediately above the protection pattern 60.

In this embodiment, as illustrated in Fig. 10B, in alignment between the substrate 311 and the mold 250, the overlay pattern 24 formed in the outer periphery of each imprint region on the substrate 311 is shared by adjacent imprint regions. With this, as compared to the second embodiment, the region of the overlay pattern 24 formed on the substrate 311 can be reduced, and the region where the main pattern is formed can be increased.

Fig. 11 is a view illustrating a first pattern 100 of an imprint material 19 formed on the first imprint region on the substrate, and a second pattern 101 of the imprint material 19 formed on the second imprint region adjacent to the first imprint region. The first pattern 100 is aligned with the overlay pattern 24 formed on the substrate 311, and a first portion 111 used for the alignment is formed on the overlay pattern 24.

When the imprint process is performed, using the mold 250, on the second imprint region adjacent to the first imprint region, the imprint material 19 is filled between the substrate 311 and the mold 250. Since the first pattern 100 formed in the first imprint region and the imprint material 19 arranged in the second imprint region are formed of the same material and have the same refractive index, the boundary therebetween cannot be optically detected by a measurement unit 13. Therefore, in an overlap region R6, the measurement unit 13 can measure the relative position between the overlay pattern 24 on the substrate and the overlay pattern 254 of the mold 250 without being hindered by the first portion 111 of the first pattern 100.

The sequence of the imprint process in the third embodiment is basically similar to that in the first embodiment, but alignment between the substrate 311 and the mold 250 in step S107 is different. In step S107, the measurement unit 13 measures the relative position between the overlay pattern 24 formed on the substrate 311 and the overlay patterns 53 and 254 provided on the mold 250. Based on the relative position between the overlay pattern 24 and the overlay patterns 53 and 254 measured by the measurement unit 13, the substrate stage 4 is driven to align the second imprint region on the substrate 70 and the pattern region 51 of the mold 50. As has been described above, through steps S100 to S104, the first portion 111 of the first pattern 100 is formed on the overlay pattern 24 formed in the overlap region R6 of the substrate 311. However, in step S105, the imprint material 19 is filled between the first portion 111 of the first pattern 100 and the pattern region 51 of the mold 250, more specifically, between the first portion 111 and the protection pattern region R5. With this, it is possible to measure the relative position between the overlay pattern 24 and the overlay pattern 254 without being hindered by the first portion 111 in the overlap region R6. In other words, in step S102 (first alignment step) and step S107 (second alignment step), it is possible to align the substrate 311 using the same overlay pattern 24 formed on the substrate 311.

The pattern of a cured product formed using the imprint apparatus 1 in the embodiment is used permanently for at least some of various kinds of articles or temporarily when manufacturing various kinds of articles. The articles are an electric circuit element, an optical element, a MEMS, a recording element, a sensor, a mold, and the like. Examples of the electric circuit element are volatile and nonvolatile semiconductor memories such as a DRAM, a SRAM, a flash memory, and a MRAM and semiconductor elements such as an LSI, a CCD, an image sensor, and an FPGA. Examples of the mold are molds for imprint.

The pattern of the cured product is directly used as the constituent member of at least some of the above-described articles or used temporarily as a resist mask. After etching or ion implantation is performed in the substrate processing step, the resist mask is removed.

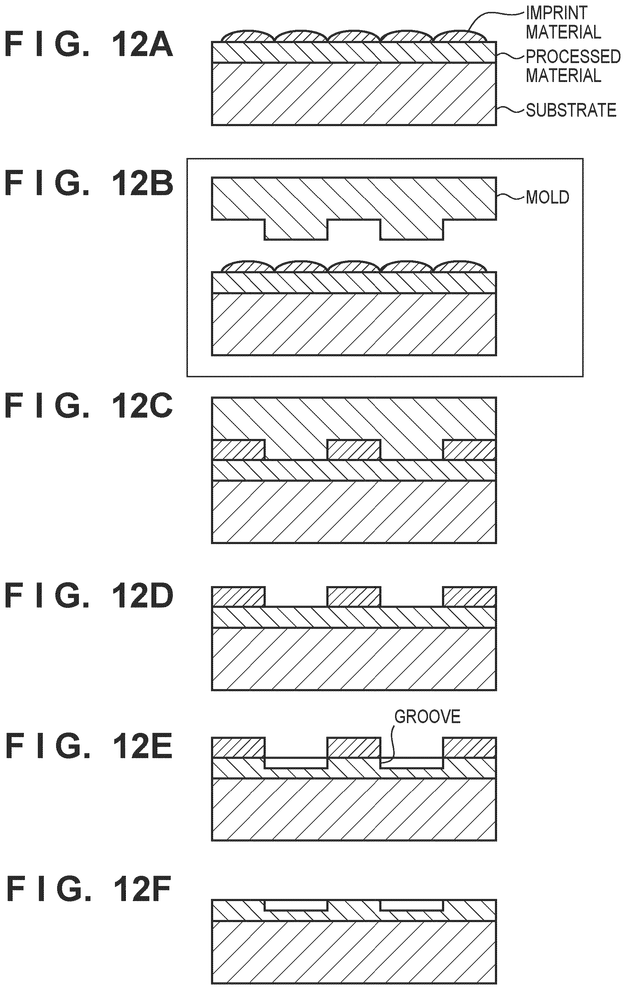

Next, description regarding a detailed method of manufacturing an article is given. As illustrated in Fig. 12A, the substrate such as a silicon wafer with a processed material such as an insulator formed on the surface is prepared. Next, an imprint material is applied to the surface of the processed material by an inkjet method or the like. A state in which the imprint material is applied as a plurality of droplets onto the substrate is shown here.

As shown in Fig. 12B, a side of the mold for imprint with a projection and groove pattern is formed on and caused to face the imprint material on the substrate. As illustrated in Fig. 12C, the substrate to which the imprint material is applied is brought into contact with the mold, and a pressure is applied. The gap between the mold and the processed material is filled with the imprint material. In this state, when the imprint material is irradiated with light serving as curing energy through the mold, the imprint material is cured.

As shown in Fig. 12D, after the imprint material is cured, the mold is released from the substrate. Thus, the pattern of the cured product of the imprint material is formed on the substrate. In the pattern of the cured product, the groove of the mold corresponds to the projection of the cured product, and the projection of the mold corresponds to the groove of the cured product. That is, the projection and groove pattern of the mold is transferred to the imprint material.

As shown in Fig. 12E, when etching is performed using the pattern of the cured product as an etching resistant mask, a portion of the surface of the processed material where the cured product does not exist or remains thin is removed to form a groove. As shown in Fig. 12F, when the pattern of the cured product is removed, an article with the grooves formed in the surface of the processed material can be obtained. The pattern of the cured material is removed here, but, for example, the pattern may be used as a film for insulation between layers included in a semiconductor element or the like without being removed after processing, in other words as a constituent member of the article.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. An imprint method of forming a pattern in an imprint material arranged on each of a first region on a substrate and a second region including an overlap region overlapping an edge of the first region, comprising:
forming, in the imprint material on the first region, a first pattern including a main pattern and a first portion formed on an overlay pattern formed in the overlap region, and
forming, in the imprint material on the second region, a second pattern including a main pattern and a second portion covering the first portion of the first pattern,
wherein in the forming the second pattern, the second pattern is formed such that a film thickness of a pattern formed in the overlap region is greater than a film thickness of the main pattern of the second pattern.

2. The method according to claim 1, wherein a height of the second portion of the second pattern is not less than a height of the main pattern of the second pattern.

3. The method according to claim 1, wherein a height of the second portion of the second pattern is greater than a height of the first portion of the first pattern.

4. The method according to claim 1, wherein
the main pattern of the first pattern is formed in a central region of the first region, and
the second portion of the second pattern is formed in a peripheral region around the central region of the first region.

5. The method according to claim 1, wherein
the forming the first pattern includes aligning the substrate to adjust a position where the first pattern is formed in the first region,
the forming the second pattern includes aligning the substrate to adjust a position where the second pattern is formed in the second region, and
in the aligning the substrate to adjust a position where the first pattern is formed in the first region and the aligning the substrate to adjust a position where the second pattern is formed in the second region, the substrate is aligned using the same overlay pattern formed on the substrate.

6. A mold used to form a pattern in an imprint material on a substrate, comprising:
a base material; and
a pattern region that is provided on a surface of the base material to face the substrate and comes into contact with the imprint material,
wherein
the pattern region includes a main pattern region where a main pattern to be transferred to the imprint material is formed, and a protection pattern region provided around the main pattern region and formed with a protection pattern used to form a pattern in the imprint material on an overlay pattern formed on the substrate, and
the protection pattern includes a recess depressed from the main pattern region.

7. The mold according to claim 6, wherein a depth of the recess is not less than a depth of a recess portion forming the main pattern.

8. The mold according to claim 6, wherein
the main pattern region has a rectangular outer peripheral shape, and
the protection pattern region is provided in a region around the main pattern region along a first side and a second side in contact with each other of four sides defining the rectangle.

9. The mold according to claim 8, wherein
the pattern region further includes an overlay pattern region where an overlay pattern used for alignment with an overlay pattern formed on the substrate is formed, and
the overlay pattern region is provided in a region around the main pattern region and along a third side and a fourth side facing the first side and the second side, respectively, of the four sides.

10. The mold according to claim 6, wherein
the pattern region further includes an overlay pattern region where an overlay pattern used for alignment with an overlay pattern formed on the substrate is formed, and
the overlay pattern region is provided in a region between the main pattern region and the protection pattern region.

11. The mold according to claim 10, wherein
the recess forming the protection pattern extends to the overly pattern region, and
the overlay pattern formed in the overlay pattern region is formed by a recess portion formed in the recess.

12. The mold according to claim 6, wherein
an overlay pattern used for alignment with an overlay pattern formed on the substrate is also formed in the protection pattern region, and
the overlay pattern formed in the protection pattern region is formed by a recess portion formed in the recess.

13. An imprint apparatus that forms a pattern in an imprint material on a substrate by using a mold, comprising:
a mold holding unit configured to hold the mold; and
a substrate holding unit configured to hold the substrate,
wherein the mold includes a mold defined in claim 6.

14. An article manufacturing method comprising:
forming a pattern on a substrate using an imprint method defined in claim 1;
processing the substrate on which the pattern is formed in the forming; and
manufacturing an article from the processed substrate.
